## Europäisches Patentamt
## European Patent Office
## Office européen des brevets

(19)

(11) Veröffentlichungsnummer: **0 169 961**
**B1**

(12) **EUROPÄISCHE PATENTSCHRIFT**

(45) Veröffentlichungstag der Patentschrift: **29.08.90**

(51) Int. Cl.$^5$: **H 03 H 17/04**

(21) Anmeldenummer: **85101395.3**

(22) Anmeldetag: **09.02.85**

(54) **Digitales Filter.**

(30) Priorität: **30.07.84 DE 3428105**

(43) Veröffentlichungstag der Anmeldung:
**05.02.86 Patentblatt 86/06**

(45) Bekanntmachung des Hinweises auf die
Patenterteilung:
**29.08.90 Patentblatt 90/35**

(84) Benannte Vertragsstaaten:
**AT CH DE FR GB LI NL**

(56) Entgegenhaltungen:
**GB-A-2 075 299**

**SIEMENS FORSCHUNGS- &
ENTWICKLUNGSBERICHTE, Band 6, Nr. 4, 1977,
Seiten 191-197, Springer Verlag, Berlin, DE; H.
SCHRÖDER: "Fast variable digital filters with
programmable table look-up"**

(73) Patentinhaber: **ANT Nachrichtentechnik GmbH
Gerberstrasse 33
D-7150 Backnang (DE)**

(72) Erfinder: **Göckler, Heinz, Dipl.-Ing.
Elbinger Strasse 52
D-7150 Backnang (DE)**

(74) Vertreter: **Wiechmann, Manfred, Dipl.-Ing.
ANT Nachrichtentechnik GmbH Gerberstrasse
33 Postfach 11 20
D-7150 Backnang (DE)**

EP 0 169 961 B1

## Beschreibung

Die Erfindung betrifft ein digitales Filter zur angenäherten Nachbildung der Wirkungsfunktion (Transmittanz) eines analogen Potenztiefpaßfilters nach dem Oberbegriff des Patentanspruches 1. Solche digitalen Filter werden insbesondere dort benötigt, wo bischer entsprechende analoge Potenztiefpaßfilter eingesetzt worden sind, also beispielsweise in Tonstudios oder bei der Sprach-, Musik- Audiosignalverarbeitung, wobei Filtergrade N von 1 bis 3, eventuell auch 4 oder 5 in Frage kommen.

In der Zeitschrift "Archiv für Elektronik und Übertragungstechnik", Band 36 (1982) Seiten 229 bis 237 sind verschiedene Möglichkeiten für die Realisierung eines variablen digitalen Filters mit veränderbaren Grenzfrequenzen diskutiert. Dort wird die Kombination eines Koeffizientenrechners mit einem einstellbaren digitalen Filter vorgeschlagen. Es wird angegeben, daß der Entwurf des Filters auf einem Mikrorechner durchgeführt werden kann.

Versuche haben gezeigt, daß die in dieser Veröffentlichung verwendeten Transformationen zu einer schlechten Annäherung der Wirkungsfunktion des digitalen Filters an die Wirkungsfunktion (Wunschverlauf) des nachzubildenden analogen Potenztiefpaßfilters führen, jedenfalls wenn der Schaltungsaufwand in bestimmten Grenzen gehalten wird.

In der DE—OS 30 34 584 ist ein Entwicklungsverfahren für ein Digitalfilter angegeben. Dabei wird ein Algorithmus verwendet, der es ermöglicht, ausgehend von vorgegebenen Werten für Gütefaktor, Mittenfrequenz, Abtastfrequenz und Verstärkung die Koeffizienten eines rekursiven Digitalfilters zu errechnen. Von dem dort angegebenen Algorithmus wird bei der hier vorliegenden Erfindung kein Gebrauch gemacht.

Dies gilt auch für die DE—OS 31 16 042, bei der es um die Realisierung eines variablen digitalen Potenzfilters N-ter Ordnung (N = (1), 2, 3, ...) geht, das einen Frequenzgang aufweist, der von demjenigen analoger Potenzfilter nicht unerheblich abweicht. Es handelt sich dabei um eine Ausgestaltung dessen, was in der oben erwähnten Zeitschrift "Archiv für Elektronik und Übertragungstechnik" zu finden ist.

Es ist Aufgabe der Erfindung, ein insbesondere einstellbares digitales Filter anzugeben, das den Wunschverlauf der Filtercharakteristik, der beim analogen Filter auftritt, gut annähert.

Ausgehend von den Merkmalen des Oberbegriffes des Patentanspruches 1, wird diese Aufgabe durch die im Kennzeichen angegebenen Merkmale gelöst. Vorteilhafte Weiterbildungen sind in den Unteransprüchen wiedergegeben.

Die Erfindung ist nicht auf eine Ausführungsform eines digitalen Potenztief- (Patentanspruch 1) oder -hochpaßfilters (Patentanspruch 2) in Kaskadenschaltung beschränkt, für welche im Patentanspruch 1 die Koeffizienten angegeben sind; sie umfaßt vielmehr auch äquivalente Filter, die sich mit bekannten Umrechnungsmethoden (vgl. z.B. die weiter unten angegebenen Literaturstellen von Antoniou und Rabiner) entwickeln lassen, wie beispeilsweise Filter in der direkten Form oder in der Parallelform, wobei die parallelen Teilfilter der Parallelform selbst wieder beliebige Strukturen haben können, beispielsweise Zustandsraumstrukturen nach der DE-Patentanmeldung P34 39 977 oder nach Barnes (IEEE Transactions on Circuits and Systems, Vol. CAS—31, No. 7, July 1984, Seiten 602—608).

Zur Vereinfachung der Einstellmöglichkeiten können Einstellmittel für den Filtergrad N und ein Einsteller für die Durchlaßgrenzfrequenz $f_d$ vorgesehen sein. Hiervon wird eine Steuerschaltung gesteuert und bevorzugt auch ein Koeffizientenspeicher zum Abruf unveränderbarer Koeffizienten. Weiterhin wird der Steuerschaltung eine Wunschfrequenz $f_w$ zugeführt, die durch einen Geber in Abhängigkeit von anderen Größen gesteuert sein kann. Diese Frequenz $f_w$, bei welcher der Betrag der Wirkungsfunktion des digitalen Filters dem Betrag der Wirkungsfunktion des nachzubildenden Potenztiefpaßfilters entspricht, kann beispielsweise der einstellbaren 3dB-Grenzfrequenz $f_d$ entsprechen oder auch konstant, zum Beispiel gleich $f_{max}$ (Maximale Nutzfrequenz) sein. Durch die selbsttätig arbeitende Steuerschaltung, der auch Steuermittel und der Koeffizientenspeicher zugerechnet werden können, werden dem Filterglied selbsttätig diejenigen Koeffizienten übermittelt, die zur Erzeugung einer filtercharakteristik entsprechend den eingestellten Werten N und $f_d$ nötig sind.

Mit dem digitalen Filter nach der Erfindung läßt sich bei relativ geringem Aufwand eine gute Approximation der Wirkungsfunktion des digitalen Filters an die Wirkungsfunktion des nachzubildenden analogen Potenztiefpaßfilters erreichen. Durch Einstellmöglichkeiten, von denen insbesondere der Einsteller für die 3dB-Grenzfrequenz $f_d$ der Wirkungsfunktion stufenlos einstellbar sein kann, ergibt sich eine leichte Handhabbarkeit in der Praxis, beispielsweise in einem Tonstudio. Insbesondere bei einem Filtergrad von mehr als 1 kann der Schaltungs- und Steueraufwand geringer als bei bekannten einstellbaren digitalen Filtern sein.

Eine besonders einfache Filtergestaltung ergibt sich, wenn für Koeffizienten, die sich bei Ausnutzung der Einstellmöglichkeiten des Filters nicht verändern, ein Koeffizientenspeicher vorgesehen ist, in welchen Koeffizientensignale, insbesondere die Koeffizientensignale "1" und "0" fest eingespeichert sind. Es ist dann für diese Koeffizienten lediglich noch ein selbsttätig arbeitender Teil (Steuermittel) einer Steuerschaltung nötig, der den Auslesevorgang des Koeffizientenspeichers entsprechend dem eingestellten Filtergrad N und der zugehörigen Zuordnung der ausgelesenen Koeffizientensignale steuert.

Wird das digitale Filter als Kaskadenschaltung mit zwei Filterblöcken in der zweiten kanonischen Form ausgebildet, so ergibt sich der Vorteil, daß von dem Koeffizientenspeicher eine ganze Reihe von fest

EP 0 169 961 B1

eingespeicherten Koeffizientensignalen bei jeder Neueinstellung der Einstellmöglichkeiten lediglich abgerufen zu werden braucht; die Steuerschaltung braucht dabei nur so gestaltet zu sein, daß der von ihr ermittelte Wert $z_0$ nach Vorzeichenumkehr unmittelbar als einer der im Patentanspruch 1 angegebenen Koeffizienten an das Filterglied abgegeben wird; außerdem braucht der Aufwand in der Steuerschaltung für die Ermittlung der im Patentanspruch 1 angegebenen Koeffizienten b und C nur relativ gering zu sein, weil dafür nur Addierer, Multiplizierer, ein $e^x$-Funktionsgeber und ein Cosinus-Funktionsgeber benötigt werden.

Sollen für ein Filter nach Anspruch 2 zur Nachbildung eines analogen Potenzhochpaßfilters die Koeffizienten bestimmt werden, so werden zunächst die Hochpaß-Grenzfrequenz $H_{f_d}$ und die Hochpaß-Wunschfrequenz $H_{f_w}$ umgerechnet nach folgender Gleichung für die

Tiefpaß-Grenzfrequenz: $f_d = f_A - H_{f_d}$ bzw. für die
Tiefpaß-Wunschfrequenz: $f_w = f_A - H_{f_w}$.

Mit diesen Werten für $f_d$ und $f_w$ folgt nun die Bestimmung der Koeffizienten nach Anspruch 1. Daraus wird durch die Umkehrung bestimmter Vorzeichen der Koeffizienten wieder in den gewünschten Hochpaß (nach Anspruch 2) zurücktransformiert.

Weitere Vorteile ergeben sich aus der nun folgenden Beschreibung eines Ausführungsbeispiels, der jedoch noch einige grundsätzlich Überlegungen vorangestellt werden.

Beispielsweise bei analogen Mischpulten sind die Tiefpaßfilterfunktionen als Frequenzgänge von Potenzfiltern spezifiziert. Es wird dabei eine einstellbare 3dB-Durchlaßgrenzfrequenz $f_d$ gefordert, und für jeden Wert von $f_d$ sind jeweils drei verschiedene Filterfunktionen mit unterschiedlicher Flankensteilheit (6, 12 und 18dB/Oktave) entsprechend den Filtergraden N = 1, 2 und 3 gefordert. Die Betragsverläufe der Transmittanzen solcher kontinuierlicher Potenzfilter werden dem Entwurf entsprechender digitaler Filterfunktionen als Wunschverläufe zugrunde gelegt. Dabei kann die Approximation des Wunschverlaufs auf den Spektralbereich von Audiosignalen von 0 bis 20kHz beschränkt werden. Der Filtergrad N der Digitalfilter wird jeweils gleich dem des entsprechenden analogen Filters gewählt, selbst wenn in Einzelfällen — bei großen Bandbreiten $f_d$ — das Digitalfilter einen geringeren Filtergrad benötigte.

Als eine Möglichkeit des Filterentwurfs bietet sich die Impuls-Invarianz-Methode an, wie beschrieben in den Literaturstellen:

Antoniou, A.: Digital filters: Analysis and design.
McGraw-Hill, Inc., New York, 1979.
Rabiner, L. R.; Gold, B.: Theory and application of digital signal processing. Prentice Hall, Englewood Cliffs N. J., 1975.

Diese Methode zeichnet sich dadurch aus, daß die Impulsantwort eines hiermit entworfenen Digitalfilters übereinstimmt mit der abgetasteten Impulsantwort des zugrunde liegenden analogen Prototypfilters mit dem gewünschten Frequenzgang. Offenbar entsteht der Frequenzgang eines derartigen Digitalfilters durch die mehrfache spektrale Überfaltung der nicht bandbegrenzten Transmittanz des analogen Prototypfilters.

Ausgangspunkt der IIM (Impuls-Invarianz-Methode) ist die Transmittanz des analogen Prototypfilters gemäß der Gleichung

$$S_{21}(w) = \frac{1}{\prod_{v=1}^{N} (w - w_{\infty v})}, \qquad (2.6)$$

mit w = u + jv (normierter komplexer Frequenzparameter mit v = normierte Frequenz)
$W_{\infty V} = U_{\infty V} + jv_{\infty V}$
$W_{\infty V}$ = Bezeichnung für v-te Polstelle,
$S_{21}(O) = 1$
und die daraus abgeleitete nicht normierte Form:

$$S_{21}(s) = \frac{\omega_d^N}{\prod_{v=1}^{N} (w\omega_d - w_{\infty v}\omega_d)} = \frac{\omega_d^N}{\prod_{v=1}^{N} (s - w_{\infty v}\omega_d)}, \qquad (2.12a)$$

deren Pole alle einfach sind (Potenzfilter). Hierin bedeuten:
$S_{21}(w)$, $S_{21}(s)$ Transmittanzen analoger (Prototyp-) Filter

3

$s = w\omega_d = u\omega_d + jv\omega_d$ (nichtnormierter komplexer Frequenzparameter)

$\omega_d = 2\pi f_d$

$f_d$ Durchlaßfrequenz (eines Tiefpasses)

N Filtergrad

$z_\infty$, $w_\infty$, $s_\infty$ Bezeichnung für Polstellen.

Zur einfacheren Bestimmung der Impulsantwort wird die Transmittanz $S_{21}(s)$ durch ihre Partialbruchentwicklung dargestellt:

$$S_{21}(s) = \sum_{\nu=1}^{N} \frac{R_\nu}{s - w_{\infty_\nu}\omega_d},$$

wobei                     (2.12b)

$$R_\nu = \lim_{s \to w_{\infty_\nu}\omega_d} (s - w_{\infty_\nu}\omega_d)\, S_{21}(s).$$

Die Impulsantwort des analogen Prototypfilters, die Laplace-Rücktransformierte von Gl. (2.12b), erhält man dann in abgetasteter Form

$$h(kT) = \sum_{\nu=1}^{N} R_\nu e^{w_{\infty_\nu}\omega_d kT} = \sum_{\nu=1}^{N} R_\nu e^{kw_{\infty_\nu}\Omega_d}$$

mit                       (2.13)

$$\Omega_d = \omega_d T$$

$$k = 1, 2, 3, \ldots$$

$$T = 1/f_A \qquad \text{Abtastperiode}$$

$$f_A \qquad \text{Abtastfrequenz.}$$

Die Transmittanz $S_{21}(z)$ des Digitalfilters ergibt sich dann als die z-Transformierte von Gl. (2.13):

$$^I S_{21}(z) = \sum_{\nu=1}^{N} \frac{R_\nu}{1 - z^{-1} e^{w_{\infty_\nu}\omega_d}} \qquad (2.14)$$

mit $w_d = 2\pi f_d$, wobei das jeweils voran- und hochgestellte "I" auf die IIM hinweist.

Das Ergebnis der IIM ist demnach ein Digitalfilter in der vierten kanonischen Form (Parallelform). Um die mit der IIM erhaltenen Ergebnisse mit den Entwürfen anderer Approximationsverfahren vergleichen zu können, muß im Fall N = 3 eine Umrechnung von Gl. (2.14) in die Kaskadenstruktur erfolgen. Die mit der IIM gewonnenen Filterparameter sind nachfolgend für N = 1, 2 und 3 angegeben, wobei jeweils so skaliert wurde, daß $|\;\|S_{21}(z=1)|\;\| = 1$ ist, und $w_\infty^*$ konjugiert komplex zu $w_\infty$ ist. Weiterhin bedeuten:

$z_0$, $w_0$, $s_0$ Bezeichnung für Nullstellen

$a_{ij}$ Zählerkoeffizienten von $S_{21}(z)$

$b_{ij}$ Nennerkoeffizienten von $S_{21}(z)$

C Konstante

$$\underline{N = 1:} \quad w_\infty = w_\infty^* = u_\infty < 0$$

$$^I S_{21}(z) = \frac{1 - e^{u_\infty\Omega_d}}{1 - z^{-1} e^{u_\infty\Omega_d}} = {}^I C_1 \frac{{}^I a_{11} z + {}^I a_{01}}{z + {}^I b_{01}} \qquad (2.15)$$

4

Nullstelle: $\qquad I_{z_0} = 0$ $\qquad$ (2.16a)

Pol: $\qquad I_{z_\infty} = e^{u_\infty \Omega_d}$ $\qquad$ (2.16b)

Zähler-Koeffizienten von $I_{S_{21}}(z)$:

$$I_{a_{11}} = 1, \quad I_{a_{01}} = 0$$

Nenner-Koeffizienten von $I_{S_{21}}(z)$:

$$I_{b_{01}} = -I_{z_\infty} = -e^{u_\infty \Omega_d} \qquad (2.16c)$$

Konstante: $I_{C_1} = 1 - I_{z_\infty} = 1 - e^{u_\infty \Omega_d}$

wobei $u_\infty = -1$ zu setzen ist.

$\underline{N = 2:}$ $\qquad w_{\infty 1} = w_{\infty 2}^* = w_\infty = u_\infty + jv_\infty$

$$I_{S_{21}}(z) = z^{-1} \frac{1 - 2e^{u_\infty \Omega_d}\cos(v_\infty \Omega_d) + e^{2u_\infty \Omega_d}}{1 - 2z^{-1}e^{u_\infty \Omega_d}\cos(v_\infty \Omega_d) + z^{-2}e^{2u_\infty \Omega_d}}$$

(2.18)

$$= I_{C_2} \frac{I_{a_{22}}z^2 + I_{a_{12}}z + I_{a_{02}}}{z^2 + I_{b_{12}}z + I_{b_{02}}}$$

Nullstelle: $\qquad I_{z_0} = 0$ $\qquad$ (2.19a)

Pole: $\qquad I_{z_\infty 1,2} = e^{u_\infty \Omega_d}\cos(v_\infty \Omega_d) \pm j\sin(v_\infty \Omega_d)$ (2.19b)

Koeffizienten: $I_{a_{22}} = I_{a_{02}} = 0, \quad I_{a_{12}} = 1$

$\qquad I_{b_{12}} = -2e^{u_\infty \Omega_d}\cos(v_\infty \Omega_d)$ $\qquad$ (2.19c)

$\qquad I_{b_{02}} = e^{2u_\infty \Omega_d}$

$\qquad I_{C_2} = 1 - 2e^{u_\infty \Omega_d}\cos(v_\infty \Omega_d) + e^{2u_\infty \Omega_d}$

wobei jeweils $u_\infty = -v_\infty = -1/\sqrt{2}$ zu setzen ist.

$\underline{N = 3:}$

$$w_{\infty 1} = w^*_{\infty 1} = u_{\infty 1} < 0$$

$$w_{\infty 2} = w^*_{\infty 3} = u_{\infty 2} + jv_{\infty 2}$$

$$^{I}S_{21}(z) = {}^{I}C_3 \frac{{}^{I}a_{11}z + {}^{I}a_{01}}{z + {}^{I}b_{01}} \frac{{}^{I}a_{22}z^2 + {}^{I}a_{12}z + {}^{I}a_{02}}{z^2 + {}^{I}b_{12}z + {}^{I}b_{02}} \qquad (2.21)$$

Nullstellen: $\qquad {}^{I}z_{01} = 0$

$$^{I}z_{02} = - \frac{e^{2u_{\infty 2}\Omega_d} - e^{(u_{\infty 1} + u_{\infty 2})\Omega_d}\left[\cos(v_{\infty 2}\Omega_d) + \frac{u_{\infty 2} - u_{\infty 1}}{v_{\infty 2}}\sin(v_{\infty 2}\Omega_d)\right]}{e^{u_{\infty 1}\Omega_d} - e^{u_{\infty 2}\Omega_d}\left[\cos(v_{\infty 2}\Omega_d) - \frac{u_{\infty 2} - u_{\infty 1}}{v_{\infty 2}}\sin(v_{\infty 2}\Omega_d)\right]}$$

$$(2.22a)$$

Pole: $\qquad {}^{I}z_{\infty 1} = e^{u_{\infty 1}\Omega_d} \qquad\qquad (2.22b)$

$$^{I}z_{\infty 2,3} = e^{u_{\infty 2}\Omega_d}\left[\cos(v_{\infty 2}\Omega_d) \pm j\sin(v_{\infty 2}\Omega_d)\right]$$

Koeffizienten: $\qquad {}^{I}a_{11} = 1, \quad {}^{I}a_{01} = 0$

$$^{I}b_{01} = -{}^{I}z_{\infty 1} = -e^{u_{\infty 1}\Omega_d}$$

$$^{I}a_{22} = 0, \quad {}^{I}a_{12} = 1, \quad {}^{I}a_{02} = -z_{02}$$

$$^{I}b_{12} = -2e^{u_{\infty 2}\Omega_d}\cos(v_{\infty 2}\Omega_d) \qquad (2.22c)$$

$$^{I}b_{02} = e^{2u_{\infty 2}\Omega_d}$$

$$^{I}C_3 = \frac{(1 + {}^{I}b_{01})(1 + {}^{I}b_{12} + {}^{I}b_{02})}{1 + {}^{I}a_{02}}$$

wobei für $u_{\infty 1} = -1$, $u_{\infty 2} = -1/2$ und $v_{\infty 2} = \sqrt{3}/2$ einzusetzen ist.

Die mit der IIM erhaltenen Filterentwurfsergebnisse zeigen gegenüber den jeweiligen Wuschverläufen für N = 1, 2 und 3, daß die Approximationsgüte mit kleiner werdender Bandbreite $f_d$ und bei genügend kleiner Bandbreite auch mit steigendem Filtergrad besser wird, da aufgrund der dann stärker bandbegrenzten Impulsantwort des analogen Prototypfilters weniger störende Beiträge durch spektrale Überfaltung auftreten. Offensichtlich ist die Impuls-Invarianz-Methode allein aber für den Entwurf der breitbrandigeren Potenztiefpaßfilter ($f_d$ = 20 kHz) ungeeignet.

Als weitere bekannte Möglichkeit des Filterentwurfs im Rahmen der vorliegenden Aufgabenstellung kommt die Matched z-Transformation (MZT) in der Form in betracht, wie in Antoniou, A.: Digital filters: Analysis and design. McGraw-Hill, Inc., New York, 1979, angegeben. Die Transmittanz eines mit dieser Methode von einem analogen Prototyptiefpaßfilter gemäß Gl. (2.12a) abgeleiteten Digitalfilters in Kaskadenstruktur ergibt sich in skalierter Form ($|M_{S_{21}}(z=1)| = 1$, wobei das hochgestellte M für die MZT steht) zu:

$$M_{S_{21}}(z) = \frac{\prod\limits_{v=1}^{N}(1-e^{W_{\infty_v}\Omega d})}{2^L} \cdot \frac{(z+1)^L}{\prod\limits_{v=1}^{N}(z-e^{W_{\infty_v}\Omega d})} z^{N-L} \qquad (2.23)$$

Die Pole und damit die Nennerkoeffizienten von $M_{S_{21}}(z)$ sind identisch mit denen, die man mit der IIM gemäß Gl. (2.14) erhält. Für die Vielfachheit L der Nullstelle $M_{z_0} = -1$ werden in der Literatur für Tiefpaßfilter unterschiedliche Werte vorgeschlagen, z.B. L = N bzw. L = 0. Für die Filtergrade N = 1 und N = 2 sind die Entwurfsergebnisse mit der IIM und der MZT mit L = 0 indentisch. Bei N = 3 mit L = 0 führt die MZT zu schlechteren Ergebnissen als die IIM, da bei der MZT in diesem Fall die korrigierende Nullstelle $I_{z_{02}}$ gemäß Gl. (2.22a) fehlt.

Bei den mit der MZT mit verschiedenen Werten von L durchgeführten Untersuchungen hat sich gezeigt, daß unabhängig vom Filtergrad N eine einfache Nullstelle $M_{z_0} = -1$ (L = 1) durchschnittlich zu den relativ besten Approximationsergebnissen für alle Filterbandbreiten führt. Die mit der MZT allein entworfenen Filter nähern wiederum vor allem bei größeren Bandbreiten $f_d$ den jeweiligen Wunschverlauf sehr schlecht an und sind daher unbrauchbar. Deshalb und wegen der aufgezeigten Verwandtschaft der MZT mit der IIM wird auf die explizite Angabe der mit Hilfe der MZT ermittelten Filterparamater verzichtet.

Vergleicht man die mit den beschriebenen Approximationsverfahren erhaltenen Filterentwurfsergebnisse miteinander, so wird erkennbar, daß offenbar der Wunschverlauf $|S_{21}(j\omega)|$ gemäß Gl. (2.12) des Betrags der Transmittanz, zwischen den mit der IIM und den mit der MZT mit L = 1 erhaltenen Approximationsergebnissen liegt.

Da diese beiden Entwurfsverfahren zu Filterfunktionen mit identischen Polen führen, ist die Idee entstanden, den Ansatz für die Transmittanz gemäß Gl. (2.23) mit L = 1 zu verallgemeinern:

$$^N S_{21}(z) = \frac{\prod\limits_{v=1}^{N}(1-e^{W_{\infty_v}\Omega d})}{1-^N z_0} \cdot \frac{z - ^N z_0}{\prod\limits_{v=1}^{N}(z-e^{W_{\infty_v}\Omega d})} z^{N-1} \qquad (2.29)$$

worin das hochgestellte N für "Nullstellenoptimierung" steht.

Die Bestimmung der optimalen Lage der reellen Nullstelle $N_{z_0}$ (Nullstellenoptimierung: NO) kann bei festgehaltenen Polen $N_{z_{\infty v}} = I_{z_{\infty v}} = M_{z_{\infty v}}$ auf analytischem Wege erfolgen. Dazu wird bei einer geeigneten, frei wählbaren Frequenz $f_w$ gefordert, daß der Betrag der Transmitanz des digitalen Filters mit dem Wunschwert $S_w$ des analogen Filters übereinstimmt ($\Omega_w = 2\pi f_w/f_A$):

$$\left| ^N S_{21}(e^{j\Omega_W}) \right| \overset{!}{=} \left| S_{21}(j2\pi f_W) \right| = S_W \qquad (2.30)$$

Die optimale Lage der Nullstelle $N_{z_0}$ erhält man dann mit Gl. (2.29) miz $z = e^{j\Omega W}$ als Lösung der quadratischen Gleichung

$$N_{z_0}^2 - 2\frac{\left(\dfrac{S_W}{C_W}\right)^2 - \cos\Omega_W}{\left(\dfrac{S_W}{C_W}\right)^2 - 1} N_{z_0} + 1 = 0 \qquad (2.31a)$$

wobei

$$C_W = \left| \frac{\prod\limits_{v=1}^{N} (1-e^{W_{\infty v} \Omega d})}{\prod\limits_{v=1}^{N} (e^{j\Omega W}-e^{W_{\infty v} \Omega d})} \right|$$

(2.31b)

Aus der Struktur von Gl. (2.31a) erkennt man (Absolutglied = 1), daß die beiden Lösungen der quadratischen Gleichung spiegelbildlich zum Einheitskreis der z-Ebene liegen. Im allgemeinen wird man die minimalphasige Lösung $|N_{z_0}| < 1$ wählen, da auch das Prototypfilter minimalphasig ist. Es existiert immer eine reelle Lösung von Gl. (2.31).

Mit der Abkürzung

$$D_W = \frac{\left(\dfrac{S_W}{C_W}\right)^2 - \cos\Omega_W}{\left(\dfrac{S_W}{C_W}\right)^2 - 1}$$

(2.32).

wobei der Wunschwert $W_w = |S_{21}(j2\pi f_w)|$ bei der Frequenz $f_w$ mit Gl. (2.12) bestimmt werden kann und $C_w$ durch Gl. (2.31b) festgelegt ist, ergeben sich mit dem Entwurfsverfahren der NO für N = 1, 2 und 3 die Filterparameter wie folgt:

$$\text{Nullstelle: } N_{z_0} = D_W \pm \sqrt{D_W^2 - 1}$$

(2.33a)

Durch die Wahl des Vorzeichens wird festgelegt, ob das resultierende Filter minimal- oder maximalphasig ist ($|N_{z_0}| \lessgtr 1$).

Pole gemäß Gln. (2.16b), (2.19b) und (2.22b):

$$N_{z_{\infty v}} = I_{z_{\infty v}}; \quad v = 1, \ldots N$$

(2.33b)

**N = 1:**

$$w_\infty = w_\infty^* = u_\infty < 0$$

$$N_{S_{21}}(z) = N_{C_1} \frac{N_{a_{11}}z + N_{a_{01}}}{z + N_{b_{01}}}$$

(2.34a)

Koeffizienten:

$$N_{a_{11}} = 1, \quad N_{a_{01}} = -N_{z_0}$$

$$N_{b_{01}} = I_{b_{01}} \quad \text{s. Gl. (2.16c)} \quad (2.34b)$$

$$N_{C_1} = \frac{1 + N_{b_{01}}}{1 + N_{a_{01}}}$$

**N = 2:**

$$w_{\infty 1} = w_{\infty 2}^* = w_\infty = u_\infty + jv_\infty$$

$$N_{S_{21}}(z) = N_{C_2} \frac{N_{a_{22}}z^2 + N_{a_{12}}z + N_{a_{02}}}{z^2 + N_{b_{12}}z + N_{b_{02}}}$$

(2.35a)

8

Koeffizienten:

$$^Na_{22} = 1, \quad ^Na_{12} = -^Nz_0, \quad a_{02} = 0$$

$$^Nb_{12} = ^Ib_{12}, \quad ^Nb_{02} = ^Ib_{02} \quad \text{s. Gl. (2.19c)}$$

$$^NC_2 = \frac{1+^Nb_{12}+^Nb_{02}}{1 + ^Na_{12}} \tag{2.35b}$$

<u>N = 3:</u>

$$w_{\infty}1 = w_{\infty}^{*}1 = u_{\infty}1 \quad <0$$

$$w_{\infty}2 = w_{\infty}^{*}3 = u_{\infty}2 + jv_{\infty}2$$

$$^NS_{21}(z) = ^NC_3 \frac{^Na_{11}z+^Na_{01}}{z+^Nb_{01}} \cdot \frac{^Na_{22}z^2+^Na_{12}z+^Na_{02}}{z^2+^Nb_{12}z+^Nb_{02}} \tag{2.36a}$$

Koeffizienten:

$$^Na_{11} = 1, \quad ^Na_{01} = -^Nz_0$$

$$^Nb_{01} = ^Ib_{01} \quad \text{s. Gl. (2.22c)}$$

$$^Na_{22} = 1, \quad ^Na_{12} = ^Na_{02} = 0 \tag{2.36b}$$

$$^Nb_{12} = ^Ib_{12}, \quad ^Nb_{02} = ^Ib_{02} \quad \text{s. Gl. (2.22c)}$$

$$^NC_3 = \frac{(1+^Nb_{01})\,(1+^Nb_{12}+^Nb_{02})}{1 + ^Na_{01}}$$

Ein Vergleich der einzelnen Frequenzgänge der mit der NO erhaltenen Filtertfunktionen mit den vorhergehenden Ergebnissen zeigt, daß die mit der NO erzielte Approximations güte immer besser ist als die mit den anderen Entwurfsverfahren erreichte Annäherung an den Wunschverlauf. Dies ist bei den breitbandigeren Filtern besonders ausgeprägt. Darüber hinaus lassen sich durch individuelle Wahl von $f_w$ noch weitere Verbesserungen erzielen.

Zusammengefaßt ergbit sich also folgendes Vorgehen beim Filterentwurf:

a) Vorgabe: (normierte) Übertragungsfunktion $S_{21}(w)$ eines analogen Potenztiefpaßfilters im w-Bereich (Gl. 2.6);

b) Transformation der Pole von $S_{21}(w)$ in den digitalen z-Bereich mit Hilfe der Impuls-Invarianz-Methode (IIM) oder (identisch) der Matched z-Transformation (MZT) (Gleichungen 2.16, 2.19, 2.22);

c) als entscheidender zusätzlicher Schritt: Bestimmung der einzigen Nullstelle des digitalen Filters im z-Bereich mit den Gleichungen 2.33a, 2.30 bis 2.32.

Unter Zugrundelegung dieses Entwurfsverfahrens gilt es nun, ein leicht bedienbars, einstellbares digitales Filter zu schaffen. Zu der hierzu gefundenen und im Patentanspruch 1 angegebenen Lösung und den Weiterbildungen gemäß den Unteransprüchen wird nun anhand der Zeichnungen ein Ausführungsbeispiel näher beschrieben.

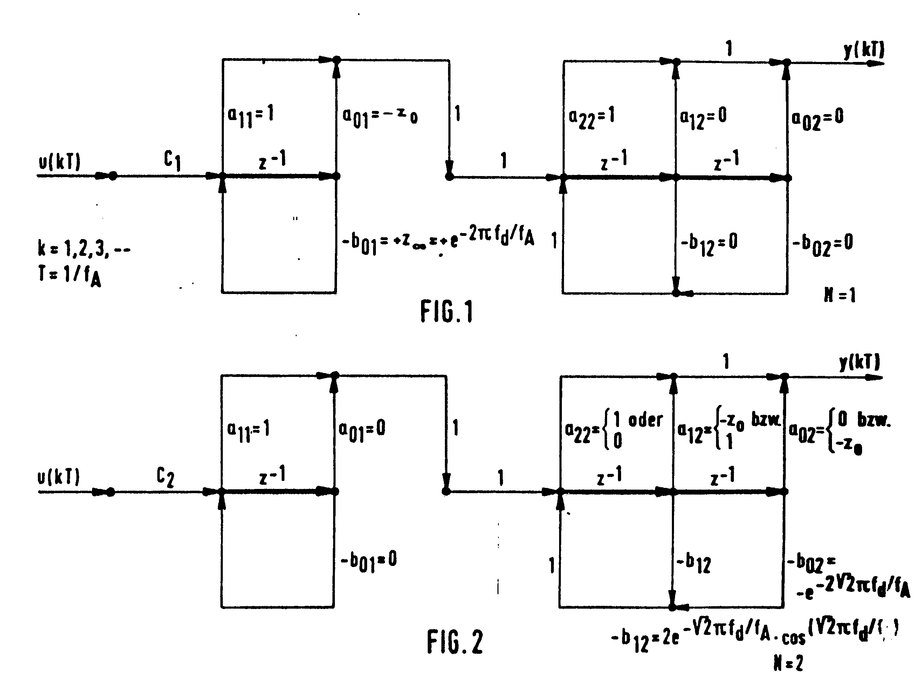

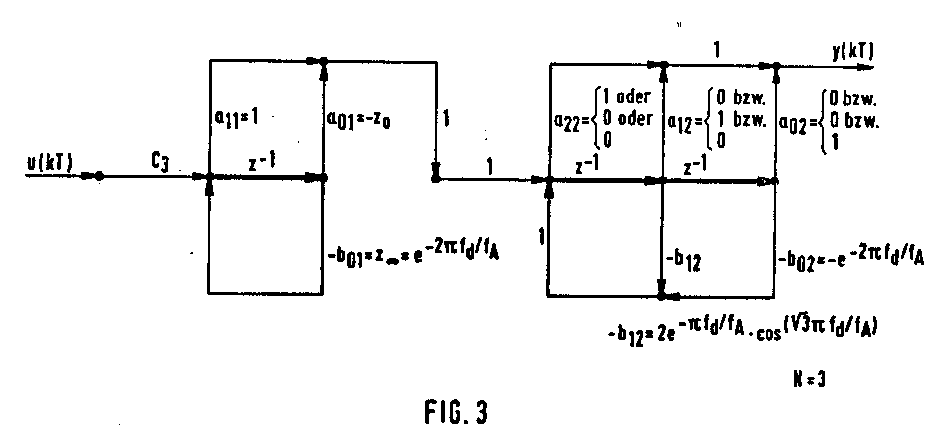

Die Fig. 1 bis 3 zeigen zunächst einmal für die Filtergrade N = 1 bis 3 eine schematische Darstellung eines digitalen Potenztiefpaßfilters als Kaskadenschaltung, wobei die Filterblöcke in der zweiten kanonischen Form nach der eingangs an zweiter Stelle ganannten Literaturstelle angegeben sind. Dabei sind als Werte für die Koeffizienten diejenigen angegeben, die nach der vorbeschriebenen Methode mit Nullstellenoptimierung ermittelt worden und in den Patentansprüche angegeben sind.

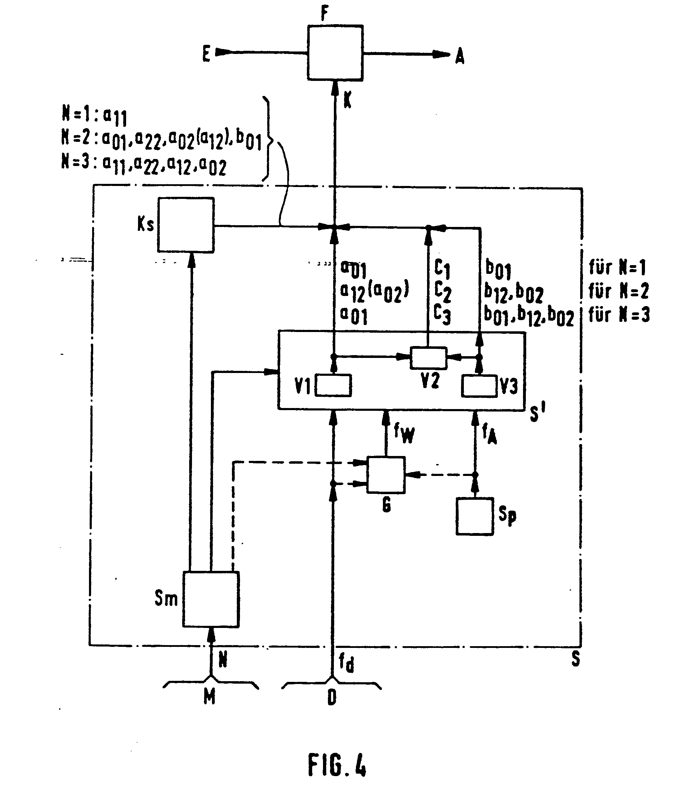

In der Praxis werden die in den Figuren 1 bis 3 angegebenen Konfigurationen dadurch verwirklicht, daß die entsprechenden Koeffizienten in einen Koeffizienteneingang K eines Filtergliedes F mit Filtersignaleingang E und Filtersignalausgang A gegeben werden, wie in Fig. 4 dargestellt.

Die Schaltungsanordnung nach Fig. 4 weist ferner ein Einstellmittel M für den Filtergrad N auf sowie einen Einsteller D für die Durchlaßgrenzfrequenz $f_d$. Die eingestellte Frequenz $f_d$ gelangt zu einer Steuerschaltung S, die ein Verknüpfungsglied V2, einen Verknüpfer V3 und weitere Teile V1 enthält, von deren Ausgängen jeweils die in Fig. 4 angegebenen Koeffizienten zum Koeffizienteneingang K gelangen.

Weitere Koeffizienten kommen von einem Koeffizientenspeicher Ks. Es handelt sich hierbei um Koeffizienten, deren Wert 1 oder 0 unabhängig von der eingestellten Durchlaßgrenzfrequenz $f_d$ ist. Von Steueremitteln Sm ist der Koeffizientenspeicher Ks jeweils nur so zu beeinflussen, daß je nach eingestelltem Filtergrad N der richtige Koeffizientensatz zum Filterglie F gelangt.

Die von dem Einstellmittel M für den Filtergrad N beherrschten Steuermittel Sm wirken außerdem auch noch auf die Steuerschaltung S' im engeren Sinn ein, damit darin jeweils durch Multiplizierer, einen $e^x$-Funktionsgeber und einen Cosinus-Funktionsgeber die richtigen Koeffizienten in Abhängigkeit sowohl von dem eingestellten Filtergrad N als auch der eingestellten Durchlaßgrenzfrequenz $f_d$ gebildet werden. Hierzu ist ein Rückgriff auf die Abtastfrequenz $f_A$ notwendig, die von einem Speicher Sp geliefert wird. Entsprechendes gilt für die Wunschfrequenz $f_w$, die prinzipiell auf verschiedene Weisen gestellt werden kann; sie kann aus der Herunterteilung der Abtastfrequenz oder durch Verfielfachung von $f_d$, jeweils eventuell beeinflußt entsprechend dem gewählten Filtergrad von den Steuermitteln Sm, oder mit Hilfe einer Kombination dieser Möglichkeiten von einem Geber G gebildet werden.

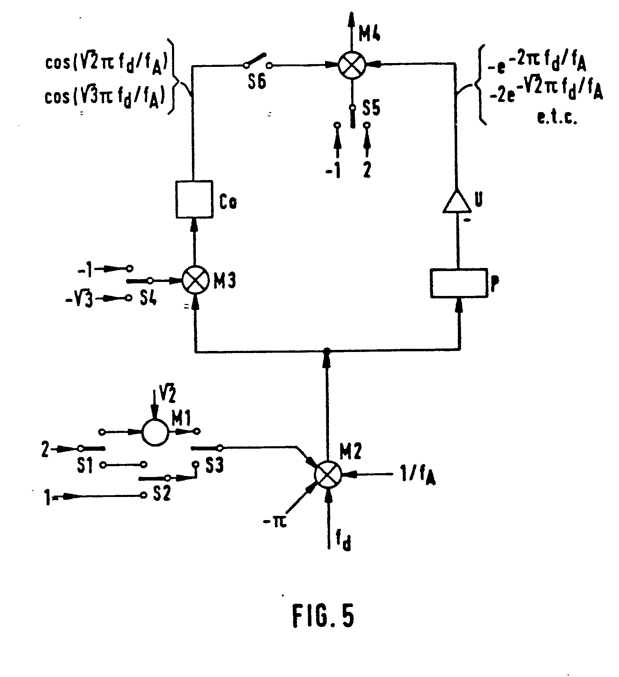

Fig. 5 zeigt, wie der Verknüpfer V3 gestaltet sein kann: Es ist ersichtlich, daß sich ein Netzwerk mit vier Multiplizierern M1 bis M4, sechs von den Steuermitteln $S_m$ (Fig. 4) gesteuerte Schaltern S1 bis S6, einem $e^x$-Funktionsgeber P, einem Vorzeicheninverter U und einem Cosinus-Funktionsgeber Co ergibt, womit sich je nach Stellung der Schalter entsprechend dem eingestellten Filtergrad und dem gerade zu erzeugenden Koeffizienten (von den insgesamt sechs von V3 lieferbaren Koeffizienten) das gewünschte Ausgangssignal des in Fig. 5 gezeigten Verknüpfers V3 erzielen läßt.

**Patentansprüche**

1. Digitales Rekursivfilter vom Grad N (N = 1, 2, 3), mit einer 3dB-Grenzfrequenz $f_d$, mit einem Filterglied (F) mit Filtersignaleingang (E) und -ausgang (A) sowie Koeffizienteneingang (K) zur Zuführung von Koeffizientensignalen von einer sebsttätigen Steuerschaltung (S), für zu filternde Signale mit einer Abtastfrequenz $f_A$, wobei die Koeffizienten abgespeichert und/oder in der Steuerschaltung (S) rechnerisch von abgespeicherten und/oder eingebbaren Werten ableitbar sind, dadurch gekennzeichnet, daß zur betragsmäßigen Nachbildung der Wirkungsfunktion (Transmittanz) eines analogen Potenztiefpaßfilters bei einer Frequenz (Wunschfrequenz) $f_w$ und zur angenäherten Nachbildung bei allen anderen Frequenzen f von f = 0 bis zu einer Maximalfrequenz $f_{max}$ die Koeffizienten

$$a_{11},\ a_{01},\ a_{22},\ a_{12},\ a_{02},\ b_{01},\ b_{12},\ b_{02},\ C_N$$

nach der eingeführten Nomenklautur für ein digitales Filter als Kaskadenschaltung mit zwei Filterblöcken in der zweiten kanonischen form folgende Werte haben:

für N = 1: $a_{11} = a_{22} = 1$, $a_{12} = a_{02} = b_{12} = b_{02} = 0$;
$$a_{01} = -z_0$$
$$b_{01} = -e^{-2\pi f_d/f_A}$$
$$C_1 = \frac{1 + b_{01}}{1 - z_0}$$

für N = 2: $a_{11} = 1$, $a_{01} = b_{01} = o$ und entweder

$$a_{22} = 1\ a_{02} = 0,\ a_{12} = -z_0$$
$$\text{oder } a_{22} = 0,\ a_{12} = 1,\ a_{02} = -z_0$$
$$b_{12} = -2e^{-\sqrt{2}\pi f_d/f_A} \cos(\sqrt{2}\pi f_d/f_A)$$
$$b_{02} = e^{-2\sqrt{2}\pi f_d/f_A}$$
$$C_2 = \frac{1 + b_{12} + b_{02}}{1 - z_0}$$

für N = 3: $a_{11} = 1$ und entweder
$$a_{22} = 1,\ a_{12} = a_{02} = 0 \text{ oder}$$
$$a_{12} = 1,\ a_{22} = a_{02} = 0 \text{ oder}$$
$$a_{02} = 1,\ a_{22} = a_{12} = 0;$$
$$a_{01} = -z_0$$
$$b_{01} = -e^{-2\pi f_d/f_A}$$
$$b_{12} = -2e^{-\pi f_d/f_A} \cos(\sqrt{3}\pi f_d/f_A)$$
$$b_{02} = e^{-2\pi f_d/f_A}$$
$$C_3 = \frac{(1 + b_{01})(1 + b_{12} + b_{02})}{(1 - z_0)}$$

jeweils mit:

$$z_0 = D_W \overset{+}{-} \sqrt{D_W^2 - 1}$$

$$D_W = \frac{\left(\frac{S_W}{C_W}\right)^2 - \cos 2\pi f_W/f_A}{\left(\frac{S_W}{C_W}\right)^2 - 1} \qquad \text{mit:}$$

$$C_W = \left| \frac{1 - e^{-2\pi f_d/f_A}}{e^{j2\pi f_W/f_A} - e^{-2\pi f_d/f_A}} \right|$$

$$S_W = \left| \frac{1}{j\frac{f_W}{f_d} + 1} \right| = \frac{1}{\sqrt{1 + (f_W/f_d)^2}} \qquad \Biggr\} \quad \text{für } N = 1,$$

$$C_W = \frac{\left| (1 - e^{-(1-j)\sqrt{2}\pi f_d/f_A})(1 - e^{-(1+j)\sqrt{2}\pi f_d/f_A}) \right|}{\left| (e^{j2\pi f_W/f_A} - e^{-(1-j)\sqrt{2}\pi f_d/f_A})(e^{j2\pi f_W/f_A} - e^{-(1+j)\sqrt{2}\pi f_d/f_A}) \right|}$$

$$S_W = \frac{1}{(j\frac{f_W}{f_d} + \frac{1-j}{\sqrt{2}})(j\frac{f_W}{f_d} + \frac{1+j}{\sqrt{2}})} \qquad \text{für } N = 2 \text{ und}$$

$$C_W = A \cdot B$$

$$A = \frac{\left| 1 - e^{-2\pi f_d/f_A} \right|}{\left| e^{j2\pi f_W/f_A} - e^{-2\pi f_d/f_A} \right|}$$

$$B = \frac{\left| (1 - e^{-(1-j\sqrt{3})\pi\frac{f_d}{f_A}})(1 - e^{-(1+j\sqrt{3})\pi\frac{f_d}{f_A}}) \right|}{\left| (e^{j2\pi\frac{f_W}{f_A}} - e^{-(1-j\sqrt{3})\pi\frac{f_d}{f_A}})(e^{j2\pi\frac{f_W}{f_A}} - e^{-(1+j\sqrt{3})\pi\frac{f_d}{f_A}}) \right|}$$

$$S_W = \frac{1}{\left| j\frac{f_W}{f_d} + 1 \right| \cdot \left| (j\frac{f_W}{f_d} + \frac{1-j\sqrt{3}}{2})(j\frac{f_W}{f_d} + \frac{1+j\sqrt{3}}{2}) \right|} \qquad \text{für } N = 3$$

$$\text{mit } j = \sqrt{-1},$$

2. Filter zur betragsmäßigen Nachbildung der Wirkungsfunktion eines analogen Potenzhochpaßfilters bei einer Frequenz (Hochpaß-Wunschfrequenz) $H_{f_w} = f_A - f_w$ (mit $f_w$ = Teifpaß-Wunschfrequenz) und zur angenäherten Nachbildung bei allen anderen Frequenzen f im Frequenzbereich $0 \leqslant f \leqslant f_{max}$, welches in Abweichung von demjenigen nach Patentanspruch 1 dadurch als Hochpaßfilter mit der Hochpaß-Grenzfrequenz $H_{f_d} = f_A - f_d$ ausgebildet ist ($f_d$ = Teifpaß-Grenzfrequenz), daß das jeweilige Vorzeichen folgender Koeffizienten geändert ist:

Für N = 1 und N = 3: $a_{01}$, $b_{01}$, $b_{12}$;

für N = 2: $a_{12}$, $b_{12}$.

3. Filter nach Anspruch 1 und 2, gekennzeichnet durch Umschaltmittel für die Vorzeichennumhehr der in Patentanspruch 1 genannten Koeffizienten.

4. Filter, dadurch gekennzeichnet, daß es bei gleichem Frequenzgang nach bekannten Umrechnungsmethoden aus demjenigen nach Patentanspruch 1, 2 oder 3 herleitbar oder in dasjenige nach Patentanspruch 1, 2 oder 3 überführbar ist, also z.B. an Stelle der Kaskadenform die direkte Form oder die Parallelform aufweist, wobei die parallelen Teilfilter der Parallelform selbst wieder beliebige Strukturen haben können.

5. Filter nach einem der Patentansprüche 1 bis 4, dadurch gekennzeichnet, daß die Koeffizienten einstellbar sind durch Einstellen der Größen N (Filtergrad) und Grenzfrequenz mit Hilfe von

— einem Einstellmittel (M) für den Filtergrad N,

— einem mittel- oder unmittelbaren Einsteller (D) für die Grenzfrequenz des Tief- bzw. Hochpaßfilters und

— selbsttätigen Steueremitteln (Sm), die vom Einstellmittel (M) beherrscht werden und die Steuerschaltung (S) und gegebenenfalls einen Koeffizientenspeicher (Ks) für unveränderliche Koeffizienten so steuern, daß jeweils die dem eingestellten Filtergrad N entsprechenden Koeffizienten ermittelt und dem Koeffizienteneingang (K) zuleitbar sind.

6. Filter nach Anspruch 5, dadurch gekennzeichnet, daß der Wert für die Frequenz $f_w$ durch die Einstellmittel (M) für den Filtergrad beeinflußbar ist.

7. Filter nach einem der Ansprüche 1 bis 6, dadurch gekennzeichnet, daß für die Frequenz $f_w$ ein Speicher oder Geber (G) vorgesehen ist, jeweils von dem gegebenenfalls vorhandenen Einstellmittel (M) oder Einsteller (D) gesteuert.

8. Filter nach Anspruch 5, 6 oder 7, dadurch gekennzeichnet, daß der Wert für die Frequenz $f_w$ durch Herunterteilung der Abtastfrequenz $f_A$ gebildet ist.

9. Filter nach Anspruch 5, 6, 7 oder 8, dadurch gekennzeichnet, daß die Frequenz $f_w$ zumindest für jeweils einen Filtergrad N einen konstanten Wert, insbesondere entsprechend der Maximalfrequenz $f_{max}$ hat.

10. Filter nach Anspruch 6, 7 oder 8, dadurch gekennzeichnet, daß der Wert für die Frequenz $f_w$ durch Vervielfachung der 3dB-Grenzfrequenz $f_d$ für das Potenztiefpaßfilter gebildet ist.

11. Filter nach Anspruch 10, dadurch gekennzeichnet, daß der Wert für die Frequenz $f_w$ demjenigen der Grenzfrequenz $f_d$ bzw. $f_A - f_d$ entspricht.

## Revendications

1. Filtre récursif numérique d'ordre N (N = 1, 2, 3), ayant une fréquence $f_d$ de pulsation de coupure à 3dB, comprenant un élément filtrant (F) avec une entrée de signal (E) et une sortie de signal (A), ainsi qu'une entrée de coefficient (K) pour l'application de signaux de coefficient venant d'un circuit de commande automatique (S), pour des signaux à filtrer présentant une fréquence d'échantillonnage $f_A$, les coefficients étant mémorisés et/ou pouvant être dérivés par calcul, dans le circuit de commande (S), de valeurs mémorisées et/ou pouvant être introduites, caractérisé en ce que, pour la simulation quant à la valeur de la fonction de travail (transmittance) d'un filtre passe-bas exponentiel de type analogique, à une fréquence (fréquence désirée) $f_w$ et pour la simulation approchée à toutes les autres fréquences f à partir de f = 0 jusqu'à une fréquence maximale $f_{max}$, les coefficients $a_{11}$, $a_{01}$, $a_{22}$, $a_{12}$, $a_{02}$, $b_{01}$, $b_{12}$, $b_{02}$, $C_N$, selon la nomenclature introduite pour un filtre numérique constitué par un circuit en cascade, avec deux blocs de filtre de la deuxième forme canonique, ont les valeurs suivantes:

pour N = 1: $a_{11} = a_{22} = 1$, $a_{12} = a_{02} = b_{12} = b_{02} = 0$;

$$a_{01} = -z_0$$
$$b_{01} = -e^{-2\pi f_d / f_A}$$
$$C_1 = \frac{1 + b_{01}}{1 - z_0}$$

pour N = 2: $a_{11} = 1$, $a_{01} = b_{01} = 0$ et, soit

$a_{22} = 1$, $a_{02} = 0$, $a_{12} = -z_0$

soit $a_{22} = 0$, $a_{12} = 1$, $a_{02} = -z_0$

$$b_{12} = -2e^{-\sqrt{2}\pi f_d / f_A} \cos(\sqrt{2}\pi f_d / f_A)$$

$$b_{02} = e^{-2\sqrt{2}\pi f_d/f_A}$$

$$C_2 = \frac{1 + b_{12} + b_{02}}{1 - z_0}$$

pour $N = 3$: $a_{11} = 1$ et, soit

$a_{22} = 1$, $a_{12} = a_{02} = 0$ soit

$a_{12} = 1$, $a_{22} = a_{02} = 0$ ou encore

$a_{02} = 1$, $a_{22} = a_{12} = 0$;

$a_{01} = -z_0$

$b_{01} = -e^{-2\pi f_d/f_A}$

$b_{12} = -2e^{-\pi f_d/f_A} \cos(\sqrt{3}\pi f_d/f_A)$

$b_{02} = e^{-2\pi f_d/f_A}$

$$C_3 = \frac{(1 + b_{01})(1 + b_{12} + b_{02})}{(1 - z_0)}$$

chaque fois avec:

$$z_0 = D_W \pm \sqrt{D_W^2 - 1}$$

$$D_W = \frac{\left(\dfrac{S_W}{C_W}\right)^2 - \cos 2\pi f_W/f_A}{\left(\dfrac{S_W}{C_W}\right)^2 - 1} \qquad \text{avec:}$$

$$C_W = \left| \frac{1 - e^{-2\pi f_d/f_A}}{e^{j2\pi f_W/f_A} - e^{-2\pi f_d/f_A}} \right|$$

$$S_W = \frac{1}{\left| j\dfrac{f_W}{f_d} + 1 \right|} = \frac{1}{\sqrt{1 + (f_W/f_d)^2}}$$

$$\left.\rule{0cm}{2.5cm}\right\} \text{pour } N = 1,$$

$$C_W = \frac{\left| (1 - e^{-(1-j)\sqrt{2}\pi f_d/f_A})(1 - e^{-(1+j)\sqrt{2}\pi f_d/f_A}) \right|}{\left| (e^{j2\pi f_W/f_A} - e^{-(1-j)\sqrt{2}\pi f_d/f_A})(e^{j2\pi f_W/f_A} - e^{-(1+j)\sqrt{2}\pi f_d/f_A}) \right|}$$

$$S_W = \frac{1}{\left(j\dfrac{f_W}{f_d} + \dfrac{1-j}{\sqrt{2}}\right)\left(j\dfrac{f_W}{f_d} + \dfrac{1+j}{\sqrt{2}}\right)} \qquad \text{pour } N = 2 \text{ et}$$

$$C_W = A \cdot B$$

$$A = \frac{\left| 1 - e^{-2\pi f_d/f_A} \right|}{\left| e^{j2\pi f_W/f_A} - e^{-2\pi f_d/f_A} \right|}$$

$$B = \frac{\left| (1-e^{-(1-j\sqrt{3})\pi\frac{f_d}{f_A}})(1-e^{-(1+j\sqrt{3})\pi\frac{f_d}{f_A}}) \right|}{\left| (e^{j2\pi\frac{f_W}{f_A}} - e^{-(1-j\sqrt{3})\pi\frac{f_d}{f_A}})(e^{j2\pi\frac{f_W}{f_A}} - e^{-(1+j\sqrt{3})\pi\frac{f_d}{f_A}}) \right|}$$

$$S_W = \frac{1}{\left| j\frac{f_W}{f_d} + 1 \right| \cdot \left| (j\frac{f_W}{f_d} + \frac{1-j\sqrt{3}}{2})(j\frac{f_W}{f_d} + \frac{1+j\sqrt{3}}{2}) \right|} \quad \text{pour } N = 3,$$

avec: $j = \sqrt{-1}$,

2. Filtre pour la simulation quant à la valeur de la fonction de travail d'un filtre passe-haut exponentiel de type analogique, à une fréquence (fréquence passe-haut désirée) $H_{f_W}=f_A-f_W$ (avec $f_W$ = fréquence passe-bas désirée) et pour la simulation approchée à toutes les autres fréquences f dans le domaine de fréquences $0 \leq f \leq f_{max}$, qui est réalisé, à la différence du filtre selon la revendication 1, comme un filtre passe-haut avec la fréquence de coupure passe-haut $H_{f_d}=f_A-f_d$, où $f_d$ = fréquence de coupure passe-bas, du fait que le signe des coefficients indiqués ci-après est modifié de la manière suivante:
pour N = 1 et N = 3: $a_{01}$, $b_{01}$, $b_{12}$;
pour n = 2: $a_{12}$, $b_{12}$.

3. Filtre selon les revendications 1 et 2, caractérisé par des moyens de commutation pour l'inversion du signe des coefficients mentionnés dans la revendication 1.

4. Filtre, caractérisé en ce que, pour le même réponse en fréquence, il peut être dérivé du filtre selon la revendication 1, 2 ou 3, ou être transformé en un filtre selon la revendication 1, 2 ou 3, selon des méthodes de conversion connues, de manière que, par exemple, à la place de la forme cascade, il présente la forme directe ou la forme parallèle, les filtres partiels parallèles de la forme parallèle pouvant eux-mêmes avoir des structures quelconques.

5. Filtre selon une des revendications 1 à 4, caractérisé en ce que les coefficients sont adjustables par l'adjustment des grandeurs (N) (ordre du filtre) et fréquence de coupure, à l'aide de
— un moyen d'adjustement (M) pour l'ordre N du filtre,
— un organe d'adjustment (D) direct ou indirect pour la fréquence de coupure du filtre passe-bas ou du filtre passe-haut et
— moyens de commande automatiques (Sm) qui sont contrôlés par le moyen d'adjustement (M) et qui commandent le circuit de commande (S) et, éventuellement, une mémoire de coefficients (Ks) pour des coefficients invariables, de manière que les coefficients correspondant à chaque fois à l'ordre N ajusté de filtre soient recherchés et puissent être appliqués à l'entrée de coefficient (K).

6. Filtre selon la revendication 5, caractérisé en ce que la valeur pour la fréquence $f_W$ peut être influencée par les moyens d'adjustement (M) pour l'ordre du filtre.

7. Filtre selon une des revendications 1 à 6, caractérisé en ce que pour la fréquence $f_W$, on a prévu une mémoire ou un générateur (G) commandé par le moyen d'ajustement (M) éventuellement présent ou par l'organe d'adjustement (D).

Filtre selon la revendication 5, 6 ou 7, caractérisé en ce que la valeur pour la fréquence $f_W$ est formée par réduction par division de la fréquence d'échantillonnage $f_A$.

9. Filtre selon la revendication 5, 6, 7 ou 8, caractérisé en ce que la fréquence $f_W$ possède une valeur constante, tout au moins pour chaque ordre N du filtre, valeur qui correspond en particulier à la fréquence maximale $f_{max}$.

10. Filtre selon la revendication 6, 7 ou 8, caractérisé en ce que la valeur pour la fréqence $f_W$ est formée par multiplication de la fréquence $f_d$ de pulsation de coupure à 3dB pour le filtre passe-bas exponentiel.

11. Filtre selon la revendication 10, caractérisé en ce que la valeur pour la fréquence $f_W$ correspond à celle de la fréquence de coupure $f_d$ ou $f_A-f_d$.

**Claims**

1. Digital recursive filter of Nth degree (N = 1, 2, 3) with a 3dB cut-off frequency $f_d$, with a filter member (F) with filter signal input (E) and filter signal output (A) as well as co-efficient input (K) for the feed of co-efficient signals from an automatic control circuit (S), for signals to be filtered at a scanning freuqency $f_A$, wherein the co-efficients are stored and/or derivable by computation in the control circuit (S) from stored and/or enterable values, characterized thereby, that for the replication in terms of amount of the characteristic function (transmittance) of an analog exponent low-pass filter at a frequency (desired frequency) $f_W$ and for the approximate replication at all other frequencies $f$ from $f = 0$ to a maximum frequency $f_{max}$, the co-efficients

$$a_{11}, a_{01}, a_{22}, a_{12}, a_{02}, b_{01}, b_{12}, b_{02}, C_N$$

according to the established nomenclature for a digital filter as cascade connection with two filter blocks in the second canonic form have the following values:

for $N = 1$: $a_{11} = a_{22} = 1$, $a_{12} = a_{02} = b_{12} = b_{02} = 0$;

$$a_{01} = -z_0$$
$$b_{01} = -e^{-2\pi f_d/f_A}$$
$$C_1 = \frac{1 + b_{01}}{1 - z_0}$$

for $N = 2$: $a_{11} = 1$, $a_{01} = b_{01} = 0$ and either

$$a_{22} = 1 \; a_{02} = 0, \; a_{12} = -z_0$$
$$\text{or } a_{22} = 0, \; a_{12} = 1, \; a_{02} = -z_0$$
$$b_{12} = -2e^{-\sqrt{2}\pi f_d/f_A} \cos(\sqrt{2}\pi f_d/f_A)$$
$$b_{02} = e^{-2\sqrt{2}\pi f_d/f_A}$$
$$C_2 = \frac{1 + b_{12} + b_{02}}{1 - z_0}$$

for $N = 3$: $a_{11} = 1$ and either

$$a_{22} = 1, \; a_{12} = a_{02} = 0 \text{ or}$$
$$a_{12} = 1, \; a_{22} = a_{02} = 0 \text{ or}$$
$$a_{02} = 1, \; a_{22} = a_{12} = 0;$$
$$a_{01} = -z_0$$
$$b_{01} = -e^{-2\pi f_d/f_A}$$
$$b_{12} = -2e^{-\pi f_d/f_A} \cos(\sqrt{3}\pi f_d/f_A)$$
$$b_{02} = e^{-2\pi f_d/f_A}$$
$$C_3 = \frac{(1 + b_{01})(1 + b_{12} + b_{02})}{(1 - z_0)}$$

wherein:

$$z_0 = D_W \pm \sqrt{D_W^2 - 1}$$

$$D_W = \frac{\left(\dfrac{S_W}{C_W}\right)^2 - \cos 2\pi f_W/f_A}{\left(\dfrac{S_W}{C_W}\right)^2 - 1} \qquad \text{wherein:}$$

$$C_W = \left| \frac{1 - e^{-2\pi f_d/f_A}}{e^{j2\pi f_W/f_A} - e^{-2\pi f_d/f_A}} \right|$$

$$\left. \vphantom{\begin{array}{c}1\\2\\3\\4\\5\end{array}} \right\} \text{for } N = 1,$$

$$S_W = \frac{1}{\left| j\dfrac{f_W}{f_d} + 1 \right|} = \frac{1}{\sqrt{1 + (f_W/f_d)^2}}$$

15

$$C_W = \frac{\left| (1-e^{-(1-j)\sqrt{2}\pi f_d/f_A})(1-e^{-(1+j)\sqrt{2}\pi f_d/f_A}) \right|}{\left| (e^{j2\pi f_W/f_A} - e^{-(1-j)\sqrt{2}\pi f_d/f_A})(e^{j2\pi f_W/f_A} - e^{-(1+j)\sqrt{2}\pi f_d/f_A}) \right|}$$

$$S_W = \frac{1}{(j\dfrac{f_W}{f_d} + \dfrac{1-j}{\sqrt{2}})(j\dfrac{f_W}{f_d} + \dfrac{1+j}{\sqrt{2}})} \qquad \text{for } N = 2 \text{ and}$$

$$C_W = A \cdot B$$

$$A = \frac{\left| 1-e^{-2\pi f_d/f_A} \right|}{\left| e^{j2\pi f_W/f_A} - e^{-2\pi f_d/f_A} \right|}$$

$$B = \frac{\left| (1-e^{-(1-j\sqrt{3})\pi\frac{f_d}{f_A}})(1-e^{-(1+j\sqrt{3})\pi\frac{f_d}{f_A}}) \right|}{\left| (e^{j2\pi\frac{f_W}{f_A}} - e^{-(1-j\sqrt{3})\pi\frac{f_d}{f_A}})(e^{j2\pi\frac{f_W}{f_A}} - e^{-(1+j\sqrt{3})\pi\frac{f_d}{f_A}}) \right|}$$

$$S_W = \frac{1}{\left| j\dfrac{f_W}{f_d} + 1 \right| \cdot \left| (j\dfrac{f_W}{f_d} + \dfrac{1-j\sqrt{3}}{2})(j\dfrac{f_W}{f_d} + \dfrac{1+j\sqrt{3}}{2}) \right|} \qquad \text{for } N = 3$$

wherein $j = \sqrt{-1}$,

2. Filter for the replication in terms of amount of the characteristic function of an analog exponent high-pass filter at a frequency (desired high-pass frequency) $H_{f_w}=f_a-f_w$ (wherein $f_w$ = desired low-pass frequency) and for the approximate replication at all other frequencies in the frequency range $0 \leq f \leq f_{max}$, which filter is in departure from that according to patent claim 1 constructed as high-pass filter with the high-pass limit frequency $H_{f_d}=f_A-f_d$ ($f_d$ = low-pass cut-off frequency) thereby, that the respective sign of the following co-efficients is changed: for N = I and N = 3: $a_{01}$, $b_{12}$; for N = 2: $a_{12}$, $b_{12}$.

3. Filter according to claims 1 and 2, charcterised by change-over switch means for the reversal of sign of the co-efficients named in patent claim 1.

4. Filter characterised thereby, that it is derivable from or convertible into that according to patent claim 1, 2 or 3 by known recomputation methods and for the same frequency response characteristic, thus for example in place of the cascade form displays the direct form or the parallel form, wherein the parallel partial filters of the parallel form can themselves again have any desired structures.

5. Filter according to one of the patent claims 1 to 4, characterized thereby, that the co-efficients are settable by setting of the magnitudes N (degree of filter) and cut-off frequency with the aid of
— a setting means (M) for the filter degree N,
— an indirect or direct setter (D) for the cut-off frequency of the low pass or high-pass filter and
— automatic control means (Sm), which are commanded by the setting means (M) and so control the control circuit (S) and, in a given case, a co-efficient store (Ks) for invariable co-efficients that the co-efficients corresponding to the respectively set filter degree N are determined and feedable to the co-efficient input (K).

6. Filter according to claim 5, characterised thereby, that the value for the frequency $F_W$ is influencable by the setting means (M) for the filter degree.

7. Filter according to one of the claims 1 to 6, characterised thereby, that a store or a transmitter (G), respectively controlled by the setting means (M) or setter (D) present in a given case, is provided for the frequency $f_w$.

8. Filter according to claim 5, 6 or 7, characterised thereby, that the value for the frequency $f_w$ is formed by dividing-down of the scanning frequency $f_A$.

9. Filter according to claim 5, 6, 7 or 8, characterised thereby, that the frequency $f_w$ has a constant value, in particular corresponding to the maximum frequency $f_{max}$, at least for a respective filter degree N.

10. Filter according to claim 6, 7 or 8, characterised thereby, that the value for the frequency $f_w$ is formed by multiplication of the 3dB cut-off frequency $f_d$ for the exponent low-pass filter.

11. Filter according to claim 10, characterised thereby, that the value for the frequency $f_w$ corresponds to that of the cut-off frequency $f_d$ or $f_A - f_d$.

FIG.1

FIG.2

$u(kT)$   $C_1$

$a_{11}=1$   $z^{-1}$

$a_{01}=-z_0$

$-b_{01}=+z_\infty=z+e^{-2\pi f_d/f_A}$

$a_{22}=1$   $z^{-1}$

$a_{12}=0$   $z^{-1}$

$a_{02}=0$   $y(kT)$

$-b_{12}=0$

$-b_{02}=0$

$N=1$

$k=1,2,3,--$
$T=1/f_A$

$u(kT)$   $C_2$

$a_{11}=1$   $z^{-1}$

$a_{01}=0$

$-b_{01}=0$

$a_{22}=\begin{cases}1\\0\end{cases}$ oder

$z^{-1}$

$a_{12}=\begin{cases}-z_0\\1\end{cases}$ bzw.

$z^{-1}$

$a_{02}=\begin{cases}0\\-z_0\end{cases}$ bzw.   $y(kT)$

$-b_{12}$

$-b_{02}$

$-b_{12}=2e^{-\sqrt{2}\pi f_d/f_A}\cdot\cos(\sqrt{2}\pi f_d/f_A)$

$-b_{02}=-e^{-2\sqrt{2}\pi f_d/f_A}$

$N=2$

1

FIG. 3

$a_{11}=1$

$C_3$

$u(kT)$

$z^{-1}$

$a_{01}=-z_0$

$-b_{01}=z_\infty=e^{-2\pi f_d/f_A}$

$a_{22}=\begin{cases}1 \text{ oder}\\0 \text{ oder}\\0\end{cases}$

$z^{-1}$

$a_{12}=\begin{cases}0 \text{ bzw.}\\1 \text{ bzw.}\\0\end{cases}$

$a_{02}=\begin{cases}0 \text{ bzw.}\\0 \text{ bzw.}\\1\end{cases}$

$y(kT)$

$z^{-1}$

$-b_{12}$

$-b_{02}=-e^{-2\pi f_d/f_A}$

$-b_{12}=2e^{-\pi f_d/f_A}\cdot\cos(\sqrt{3}\pi f_d/f_A)$

N = 3

FIG. 4

FIG. 5